# EUROPEAN PATENT SPECIFICATION

(11) **EP 2 241 954 B1**
(45) Date of publication and mention of the grant of the patent: **28.12.2011**
(21) Application number: 10166947.1
(22) Date of filing: 07.10.2005
(51) Int. Cl.: G06F 1/16, H01M 2/10, H04B 1/38, H04M 1/02, H05K 5/00

(54) **Portable Electronic Device with Versatile Battery Compartment**
Tragbare elektronische Vorrichtung mit vielseitigem Batteriefach
Dispositif électronique portable doté d'un compartiment de batterie polyvalent

(43) Date of publication of application: 20.10.2010
(62) Divisional of application: 08166615.8
(73) Proprietor: Research in Motion Limited, Waterloo, Ontario N2L 3W8 (CA)
(72) Inventor: Ladouceur, Norman, Waterloo Ontario N2T 1A2 (CA); Tyneski, Frank, Solana Beach, CA 92075 (US); Griffin, Jason, Kitchener Ontario N2P 2L3 (CA)
(74) Representative: Moore, Barry

(56) References cited:
- EP-A1- 1 468 933
- US-A1- 2004 233 625

## Description

This invention relates to generally portable electronic devices, including but not limited to handheld wireless communication devices. More particularly, this invention relates to means of accommodating batteries of different sizes in such devices.

Certain portable electronic devices, handheld wireless communication devices in particular, are designed to provide various battery life options, depending on different capacity batteries being used. Batteries of different capacity tend to have different physical dimensions. These differences in dimension are typically compensated for by providing battery area access doors of varying dimension, i.e. a separate battery door for each possible battery. It would be preferable to avoid such separate battery doors.

US-A-6048642 discloses a portable electronic device having a battery compartment with a removable cover able to slide relative to the battery compartment to accommodate batteries of different thickness.

EP-A-1603246 falling under the provisions of Article 54(3)EPC, discloses a portable electronic device having a battery compartment with a removable cover. US 2004/0233625 A1 also discloses. Such a device, said battery compartment and cover being configured to engage each other providing a battery compartment depth so accommodate batteries and further electronic components, wherein said batterycover comprises a central portion and an outer frame which has a shallow U-shape.

The invention therefore preferably provides various means for accommodating batteries of different dimensions, without requiring separate battery doors.

Reference will be made to "relatively thin" batteries, and "somewhat thicker" batteries. It should be understood that "relatively thin" means relative to the thickness of the "somewhat thicker" batteries, and is not intended to indicate that the "relatively thin" battery is in fact thin compared to batteries in general.

### GENERAL

According to one exemplary embodiment there may be provided a portable electronic device comprising a battery compartment and a removable cover therefor, said battery compartment and cover being configured to engage each other in one of at least two discrete relative positions, each said position providing a different battery compartment depth to accommodate batteries of at least two different sizes; wherein said battery cover comprises an outer frame and a central portion which has a shallow U-shape with an outer flange of the central portion underlying an inwardly extending flange of the outer frame, such that rotation of said central portion between alternate orientations about an axis in the plane of the cover produces a smaller battery compartment in one orientation than in the other orientation.

According to another exemplary embodiment, the central portion with its shallow U-shape is designed to engage the inwardly extending flange of the outer frame.

According to another exemplary embodiment, the shallow U-shape is designed with a degree of flexibility that enables the outer flange of the central portion with its shallow U-shape to engage and disengage the inwardly extending flange of the outer frame.

According to another exemplary embodiment, the central portion with its shallow U-shape comprises a base of generally rigid material and sides of a springy material.

According to another exemplary embodiment, the at least two different sizes are discrete sizes.

According to another exemplary embodiment, the at least two different sizes are various sizes along a continuum of sizes.

Aspects of the invention will be described or will become apparent in the course of the following detailed description and drawings of specific embodiments of the invention, as examples only.

### BRIEF DESCRIPTION OF THE DRAWINGS

Embodiments of the invention will now be described, by way of example only, with reference to the attached drawings, in which:

Fig. 1 is a perspective view of a first exemple,

Fig. 2 is a cross-sectional elevation view of the first example, with a relatively thin battery;

Fig. 3 is a cross-sectional elevation view of the first example, with a somewhat thicker battery;

Fig. 4 is a perspective view of a second example, with a relatively thin battery;

Fig. 5 is another perspective view of the second example, with a somewhat thicker battery;

Fig. 6 is a cross-sectional elevation view of the second example, with a relatively thin battery;

Fig. 7 is a cross-sectional elevation view of the second example, with a somewhat thicker battery;

Fig. 8 is a perspective view of a third example, with a relatively thin battery;

Fig. 9 is another perspective view of the third example, with a somewhat thicker battery;

Fig. 10 is a cross-sectional elevation view of the third example, with a relatively thin battery;

Fig. 11 is a cross-sectional elevation view of the third example, with a somewhat thicker battery;

Fig. 12 is a perspective view of a fourth example;

Fig. 13 is a cross-sectional elevation view of the fourth example, with a relatively thin battery;

Fig. 14 is a cross-sectional elevation view of the fourth example, with a somewhat thicker battery;

Fig. 15 is a perspective view of a fifth example, with a relatively thin battery;

Fig. 16 is another perspective view of the fifth example, with a somewhat thicker battery;

Fig. 17 is a cross-sectional elevation view of the fifth example, with a relatively thin battery;

Fig. 18 is a cross-sectional elevation view of the fifth example, with a somewhat thicker battery;

Fig. 19 is a cross-sectional elevation view of a sixth example, similar to the fifth embodiment, with a relatively thin battery;

Fig. 20 is a cross-sectional elevation view of the sixth example, with a somewhat thicker battery;

Fig. 21 is a perspective view of a seventh example;

Fig. 22 is a cross-sectional elevation view of a portion of the seventh example ;

Fig. 23 is a cross-sectional elevation view of the seventh example, with a relatively thin battery;

Fig. 24 is a cross-sectional elevation view of the seventh example, with a somewhat thicker battery;

Fig. 25 is a cross-sectional elevation view of an eighth example, with a relatively thin battery;

Fig. 26 is a cross-sectional elevation view of a portion of the cover of the eighth example;

Fig. 27 is a cross-sectional elevation view of the eighth example, with a somewhat thicker battery;

Fig. 28 is a perspective view of the battery cover of an embodiment of the invention, in a position for a relatively thin battery;

Fig. 29 is a cross-sectional elevation view the cover, corresponding to Fig. 28;

Fig. 30 is a perspective view of the battery cover of the embodiment, in a position for a somewhat thicker battery; and

Fig. 31 is a cross-sectional elevation view the cover, corresponding to Fig. 30.

### DESCRIPTION OF PREFERRED EMBODIMENTS

The accompanying drawings illustrate various aspects and exemples to accommodate batteries of different sizes.

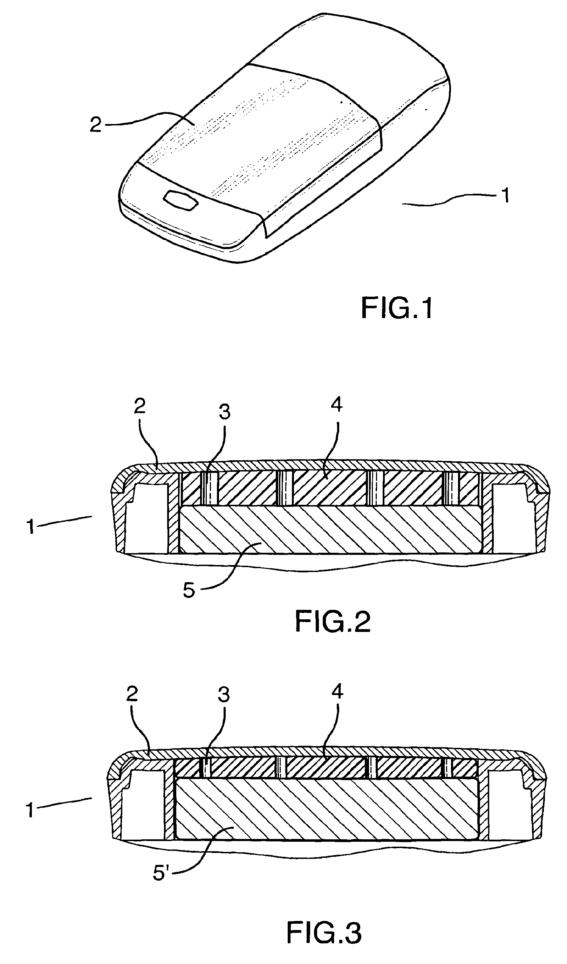

According to a first exemple, as shown in Figs. 1-3, the handheld device **1** with a cover **2** secured to the device by any suitable conventional means, over a battery compartment **3.** Inside the battery compartment, under the cover, are one or more elastomeric elements **4** which bear against an installed battery, **5** or **5'.** Fig. 2 shows a relatively thin battery **5,** such that the elastomeric elements are not compressed, or are compressed only sufficiently to keep the battery in position. Fig. 3 shows a somewhat thicker battery **5',** such that the elastomeric elements are somewhat compressed, the compression creating more space to accommodate the larger battery.

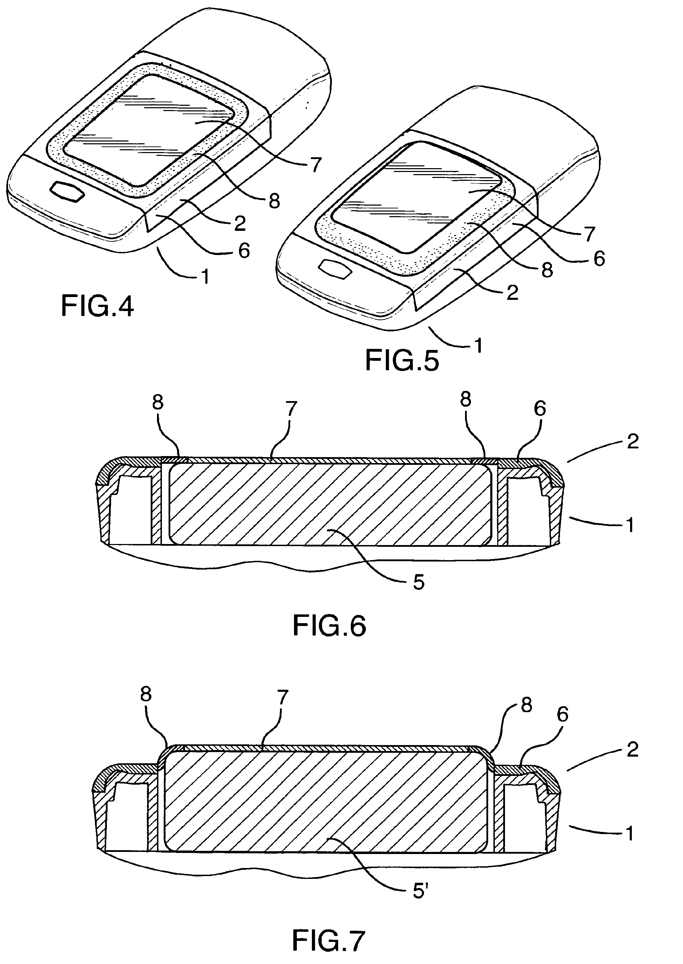

According to a second exemple, as shown in Figs. 4-7, the handheld device **1** has a cover **2** secured to the device by any suitable conventional means, over the battery compartment **3.** The cover has a generally rigid outer frame **6,** for example of hard plastic or metal, and a generally rigid centre portion **7,** again for example of hard plastic or metal. The outer frame and centre portion are connected by an elastomeric web portion **8,** molded with or otherwise connected to both the outer frame and the centre portion. As can be seen from a comparison between Figs. 4 and 5, or especially between Figs. 6 and 7, the centre portion **7** is in one position in Figs. 4 and 6, relatively flat or generally co-planar with the outer frame **6** for example, to accommodate a relatively thin battery **5.** In Figs. 5 and 7, the elastomeric web **8** is stretched, and the centre portion **7** is displaced outwardly, thereby accommodating a somewhat thicker battery **5'.**

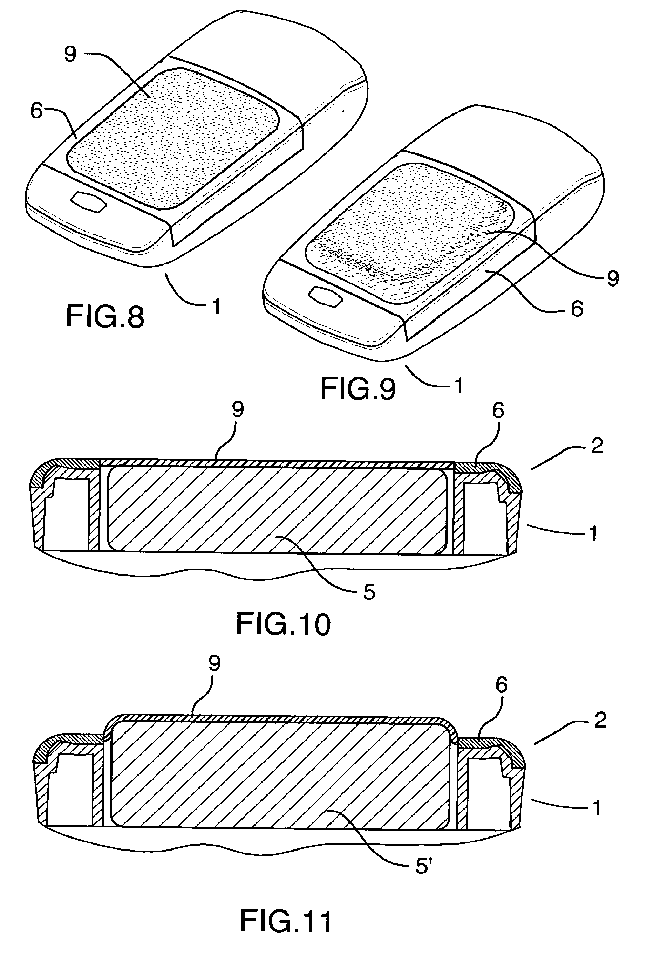

A third exemple, similar to the second example, is shown in Figs. 8-11. In this example, there is no generally rigid centre portion. Instead, there is an elastomeric portion **9** secured to the outer frame **6,** spanning across the battery compartment. As can be seen from a comparison between Figs. 8 and 9, or especially between Figs. 10 and 11, the elastomeric portion **9** is in one position in Figs. 8 and 10, relatively flat or generally co-planar with the outer frame **6** for example, to accommodate a relatively thin battery **5.** In Figs. 9 and 11, the elastomeric portion **9** is stretched, particularly towards outer edges thereof, thereby accommodating a somewhat thicker battery **5'.**

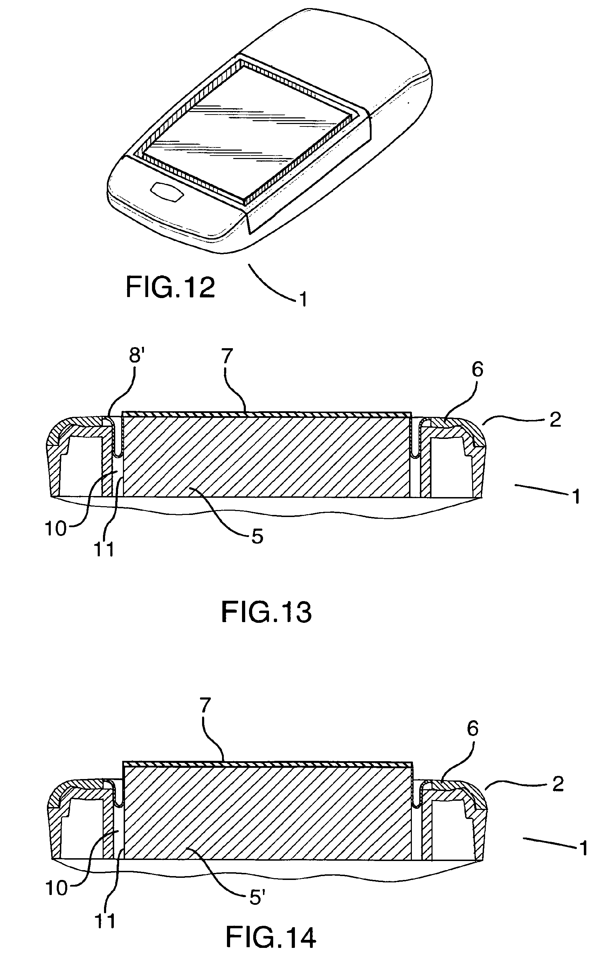

A fourth exemple, also similar to the second example, is shown in Figs. 12-14. In this example, the cover again has a generally rigid outer frame **6** and a generally rigid centre portion **7,** and the outer frame and centre portion are again connected by an elastomeric web portion. However, the elastomeric web portion **8',** is in the form of a flexible membrane, molded with or otherwise connected to both the outer frame and the centre portion. The membrane tucks into a small gap **10** between the battery **5** or **5'** and the side wall **11** of the battery compartment. As with the previous examples, Figs. 13 and 14 show the comparison between accommodating a relatively thin battery 5 and a somewhat thicker battery **5'.**

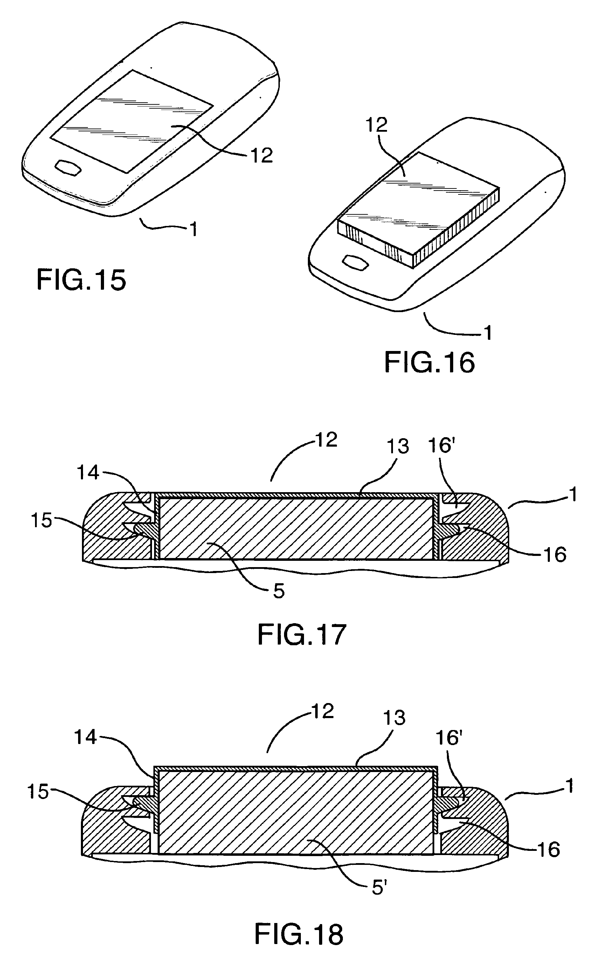

A fifth exemple is shown in Figs. 15-18. In this example, a battery cover **12** has an outer surface **13** and side walls **14** encompassing the battery **5** or **5'.** The battery cover preferably is generally rigid, but could be somewhat flexible. Extending outwardly from the side walls **14** are flexible engagement means **15** such as elastomeric or otherwise flexible tabs or a flange, which can engage corresponding recesses **16** or **16'** at two or more relative heights. The battery cover is installed by pressing it downwardly into the battery compartment, such that the flexible engagement means snap or pop into the relevant recess or recesses. One recess height, shown in Fig. 17, corresponds to a relatively thin battery **5,** while the other recess height, shown in Fig. 18, corresponds to a somewhat thicker battery **5'.** There could be additional recess heights if desired. The flexible engagement means **15** could be tabs placed at several locations around the circumference of the battery cover, with recesses at corresponding locations, or could be in the form of a continuous flange extending all the way around the battery cover. The tabs or flange could be integral to the battery cover, or could be a separate piece. Although elastomeric tabs or an elastomeric flange are primarily contemplated, it should be appreciated that analogous means could be employed instead. For example, the battery cover could be provided with a ball-spring arrangement, to engage detents at different heights in the battery compartment, or the reverse could be provided, i.e. ball-spring arrangements in the battery compartment, engaging detents in the side walls of the battery cover.

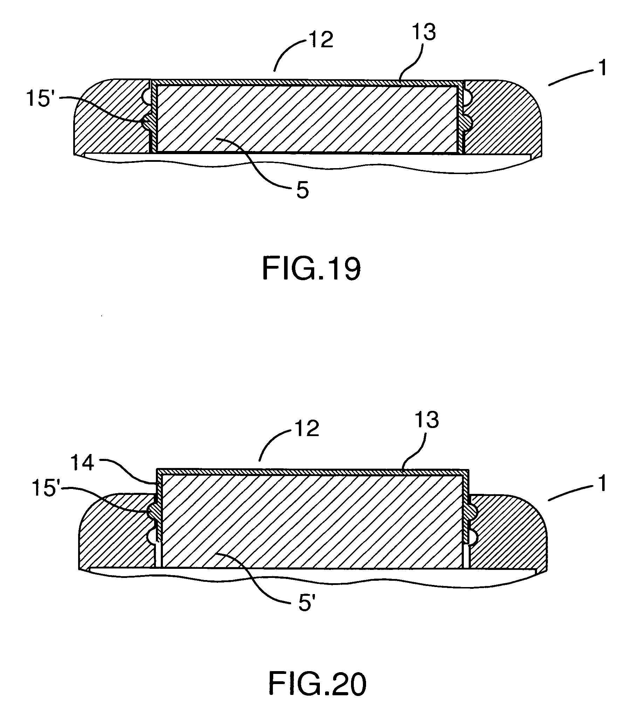

Figs. 19 and 20 show a sixth exemple, very similar to the preceding example, in which the flexible engagement means **15** is in the form of elastomeric dimples engaging corresponding recesses. The ball-spring arrangement referred to above would be somewhat similar in concept and appearance.

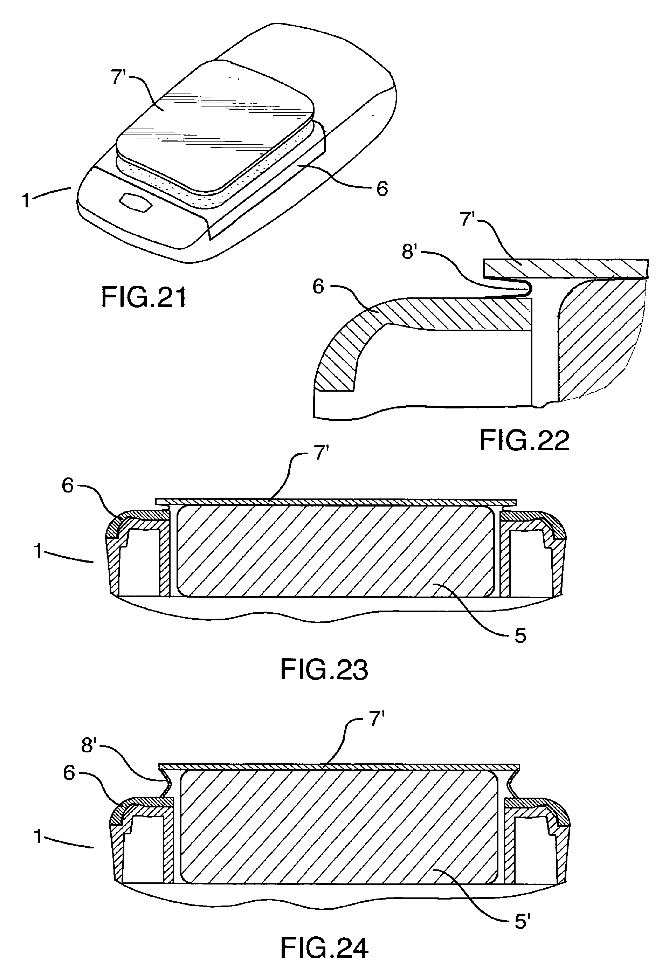

Figs. 21-24 show a seventh exemple, similar in concept to the second and fourth examples in particular. In this example, the cover has a generally rigid outer frame **6,** for example of hard plastic or metal, and a generally rigid centre portion **7',** again for example of hard plastic or metal. The outer frame and centre portion are connected by a web portion **8',** molded with or otherwise connected to both the outer frame and the centre portion. This web portion **8'** is of a springy material, biased to the position shown in Fig. 23. To accommodate a somewhat thicker battery **5',** the web portion **8'** expands outwardly as shown in Fig. 24.

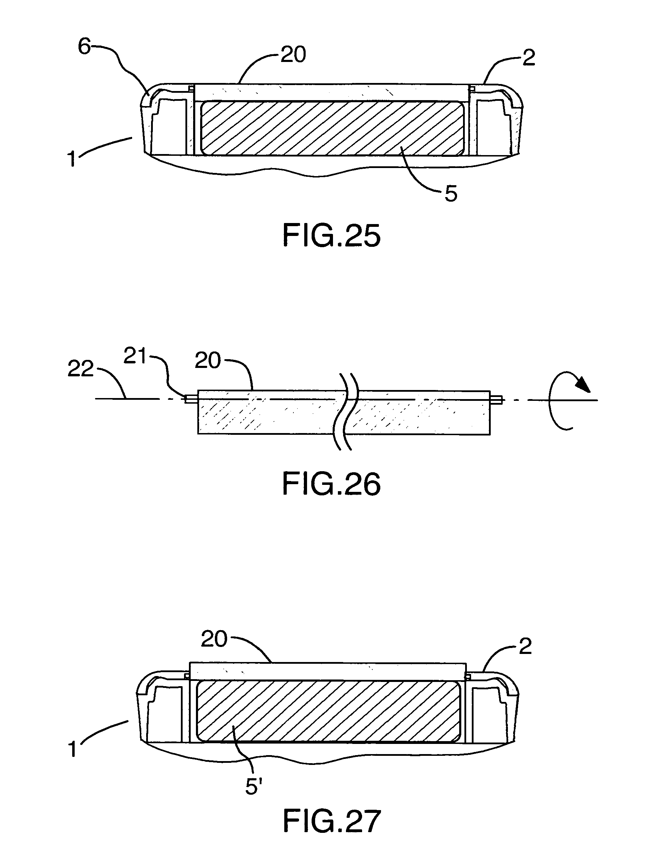

Figs. 25-27 show an eighth exemple, in which the battery cover **20** itself, or a portion thereof, is reversible and has tabs or flanges **21** displaced from the centreline **22.** As can be seen from comparing Figs. 25 and 27, flipping the cover or cover portion thus creates a smaller or larger space for the battery **5** or **5'.**

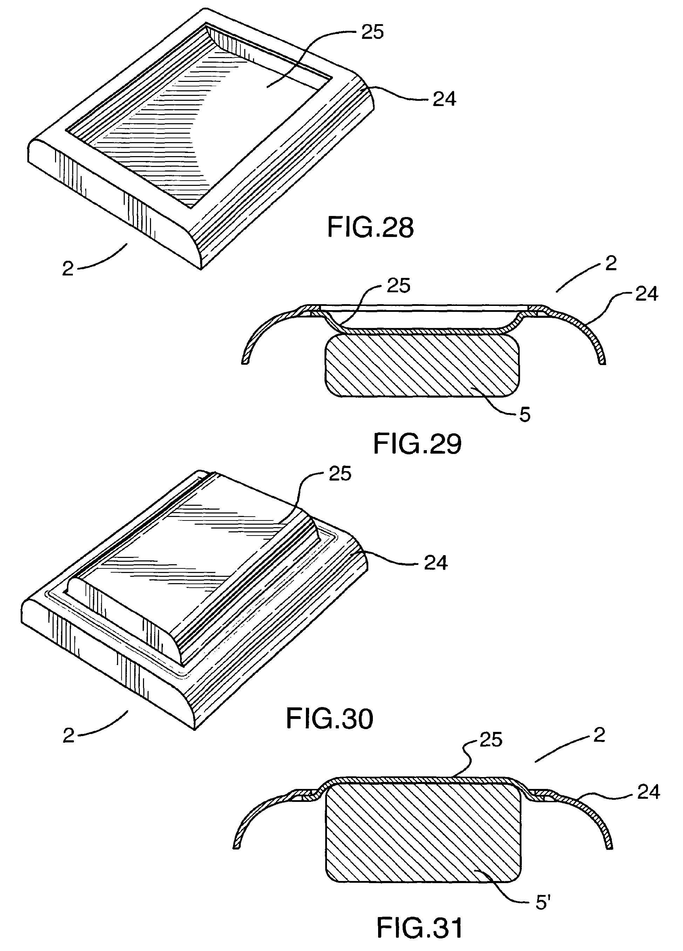

Figs. 28-31 show a exemplary embodiment of the invention, in which the battery cover **2** is in two pieces, namely an outer frame **24,** and a central portion **25.** As can be readily seen from the drawings, the central portion can be installed in one of two positions, according to a principle somewhat similar to the preceding embodiment. Depending on which orientation is used, a smaller or larger space for the battery **5** or 5' is created.

The preceding embodiment illustrates various aspects of the invention, but as example only. It will be appreciated that many additional variations and examples are possible, and will be apparent to those knowledgeable in the field of the invention. Thus the scope of the invention, as defined in the following claim, is not limited to these specific examples.

Without limiting the generality of the foregoing, further aspects may include, for example, any other obvious variations as to how the battery cover may be configured or installed to provide varying battery compartment sizes; any obvious variations in choices of materials, degree of flexibility or resilience, if any, and any obvious variations in size, shape or other characteristics not relevant to the point of the invention. It should also be noted that although certain of the exemples and embodiments above lend them selves to discrete battery sizes only, others (for example embodiments or examples with elastomeric elements) may lend themselves to a variety of battery sizes, along a continuum.

A portion of the disclosure of this document contains material which is subject to copyright protection. The copyright owner has no objection to the facsimile reproduction by anyone of the patent document or disclosure, as it appears in the Patent Office file or public records, but otherwise reserves all copyright protection whatsoever.

## Claims

1. A portable electronic device (1) comprising a battery compartment (3) and a removable cover (2) therefor, said battery compartment (3) and cover (2) being configured to engage each other in one of at least two discrete relative positions, each said position providing a different battery compartment depth to accommodate batteries (5,5') of at least two different sizes,
wherein said battery cover (2) comprises an outer frame and a central portion which has a shallow U-shape with an outer flange (25) of the central portion underlying an inwardly extending flange (24) of the outer frame, such that rotation of said central portion between alternate orientations about an axis in the plane of the cover produces a smaller battery compartment in one orientation than in the other orientation.

2. The device of claim 1 wherein the central portion with its shallow U-shape is designed to engage the inwardly extending flange of the outer frame.

3. The device of claim 1 wherein the shallow U-shape is designed with a degree of flexibility that enables the outer flange of the central portion with its shallow U-shape to engage and disengage the inwardly extending flange of the outer frame.

4. The device of claim 1 wherein the central portion with its shallow U-shape comprises a base of generally rigid material and sides of a springy material.

5. The device of claim 1 wherein the at least two different sizes are discrete sizes.

6. The device of claim 1 wherein the at least two different sizes are various sizes along a continuum of sizes.

## Patentansprüche

1. Tragbare elektronische Vorrichtung (1), die ein Batteriefach (3) und eine abnehmbare Abdeckung (2) dafür aufweist, wobei das Batteriefach (3) und die Abdeckung (2) konfiguriert sind, ineinander einzugreifen an einer von zumindest zwei getrennten relativen Positionen, wobei jede Position eine andere Batteriefachtiefe vorsieht, um Batterien (5, 5') mit zumindest zwei verschiedenen Größen aufzunehmen,
wobei die Batterieabdeckung (2) einen äußeren Rahmen und einen zentralen Teil aufweist mit einer flachen U-Form, wobei ein äußerer Flansch (25) des zentralen Teils unter einem sich nach innen erstreckenden Flansch (24) des äußeren Rahmens liegt, so dass eine Rotation des zentralen Teils zwischen wechselnden Ausrichtungen um eine Achse in der Ebene der Abdeckung ein kleineres Batteriefach in einer Ausrichtung als in der anderen Ausrichtung erzeugt.

2. Vorrichtung gemäß Anspruch 1, wobei der zentrale Teil mit seiner flachen U-Form ausgebildet ist zum in Eingriff sein mit dem sich nach innen erstreckenden Flansch des äußeren Rahmens.

3. Vorrichtung gemäß Anspruch 1, wobei die flache U-Form ausgebildet ist mit einem Flexibilitätsgrad, der ermöglicht, dass der äußere Flansch des zentralen Teils mit seiner flachen U-Form mit dem sich nach innen erstreckenden Flansch des äußeren Rahmens in Eingriff und außer Eingriff ist.

4. Vorrichtung gemäß Anspruch 1, wobei der zentrale Teil mit seiner flachen U-Form eine Basis aus im Allgemeinen steifen Material und Seiten aus einem elastischen Material aufweist.

5. Vorrichtung gemäß Anspruch 1, wobei die zumindest zwei verschiedenen Größen diskrete Größen sind.

6. Vorrichtung gemäß Anspruch 1, wobei die zumindest zwei verschiedenen Größen unterschiedliche Größen entlang eines Kontinuums von Größen sind.

## Revendications

1. Dispositif électronique portable (1) comprenant un compartiment de piles ou de batteries (3) et un capot amovible (2) pour celui-ci, ledit compartiment de piles ou de batteries (3) et ledit capot (2) étant configurés de façon à venir en prise l'un avec l'autre dans l'une d'au moins deux positions relatives individuelles, chacune desdites positions procurant une profondeur de compartiment de piles ou de batteries différente pour recevoir des piles ou des batteries (5, 5') d'au moins deux tailles différentes,
dans lequel ledit capot de piles ou de batteries (2) comprend un bâti extérieur et une partie centrale qui a une forme en U peu profonde avec un flasque extérieur (25) de la partie centrale sous-jacent à un flasque s'étendant vers l'intérieur (24) du bâti extérieur, de telle sorte que la rotation de ladite partie centrale entre des orientations différentes autour d'un axe dans le plan du capot produise un plus petit compartiment de piles ou de batteries dans une orientation que dans l'autre orientation.

2. Dispositif selon la revendication 1, dans lequel la partie centrale avec sa forme en U peu profonde est conçue de façon à venir en prise avec le flasque s'étendant vers l'intérieur du bâti extérieur.

3. Dispositif selon la revendication 1, dans lequel la forme en U peu profonde est conçue avec un degré de souplesse qui permet au flasque extérieur de la partie centrale avec sa forme en U peu profonde de venir en prise et de quitter sa prise avec le flasque s'étendant vers l'intérieur du bâti extérieur.

4. Dispositif selon la revendication 1, dans lequel la partie centrale avec sa forme de U peu profonde comprend une base en un matériau globalement rigide et des côtés en un matériau élastique.

5. Dispositif selon la revendication 1, dans lequel les au moins deux tailles différentes sont des tailles individuelles.

6. Dispositif selon la revendication 1, dans lequel les au moins deux tailles différentes ont différentes tailles le long d'un continuum de tailles.
